# EUROPÄISCHE PATENTSCHRIFT

(11) **EP 2 083 991 B1**
(45) Veröffentlichungstag und Bekanntmachung des Hinweises auf die Patenterteilung: **18.09.2013**
(21) Anmeldenummer: 07846367.6
(22) Anmeldetag: 28.11.2007
(51) Int. Cl.: B29C 59/00, B29C 59/14, C23C 14/58

(54) **VERFAHREN ZUR HERSTELLUNG EINER NANOSTRUKTUR AN EINER KUNSTSTOFFOBERFLÄCHE**
METHOD FOR PRODUCING A NANOSTRUCTURE ON A PLASTIC SURFACE
PROCÉDÉ DE FABRICATION D'UNE NANOSTRUCTURE SUR UNE SURFACE EN PLASTIQUE

(30) Priorität: 30.11.2006 DE 102006056578
(43) Veröffentlichungstag der Anmeldung: 05.08.2009
(73) Patentinhaber: Fraunhofer Gesellschaft zur Förderung der angewandten Forschung E.V., 80686 München (DE)
(72) Erfinder: MUNZERT, Peter, 07743 Jena (DE); SCHELER, Michael, 07745 Jena (DE); SCHULZ, Ulrike, 07751 Jena (DE); KAISER, Norbert, 07745 Jena (DE)
(74) Vertreter: Epping - Hermann - Fischer
(86) Internationale Anmeldenummer: PCT/DE2007/002151
(87) Internationale Veröffentlichungsnummer: WO 2008/064663

(56) Entgegenhaltungen:
- EP-A- 0 502 633
- DE-A1- 10 241 708
- US-A- 4 340 276
- US-A1- 2006 148 241

## Beschreibung

Die Erfindung betrifft ein Verfahren gemäß dem Oberbegriff des Patentanspruchs 1.

Diese Patentanmeldung beansprucht die Priorität der deutschen Patentanmeldung 10 2006 056 578.9, deren Offenbarungsgehalt hiermit durch Rückbezug aufgenommen wird.

Die Druckschrift EP 0 502 633 A2 beschreibt ein Verfahren zur Modifizierung einer Polymeroberfläche durch eine Plasma- oder Ionenbehandlung. Die Druckschrift US 2006/0148241 A1 beschreibt die Herstellung von Durchgangslöchern in einer Isolierschicht mit einem Plasmaätzverfahren.

Aus der Patentschrift DE 102 41 708 B4 ist ein Verfahren zur Reduzierung der Reflexion von Kunststoffsubstraten bekannt, bei dem an einer Oberfläche eines Substrats aus einem Kunststoff mittels eines Plasmaätzprozesses eine Nanostruktur erzeugt wird. Dabei wird die Nanostruktur durch Beschuss der Substratoberfläche mit energiereichen Ionen, welche mittels einer Plasma-Ionenquelle erzeugt werden, hergestellt.

Es hat sich herausgestellt, dass die Herstellung einer derartigen reflexionsmindernden Nanostruktur auf einigen Kunststoffen nur vergleichsweise schwer möglich ist, insbesondere nur mit vergleichsweise langen Ätzzeiten bei dem Plasmaätzprozess.

Aus der Druckschrift DE 102 41 708 B4 geht ferner hervor, dass die Dauer des Plasmaätzprozesses bei einem Substrat aus PMMA nicht mehr als 300 s betragen sollte, während zum Beispiel für das Polymer CR39 erst bei einer Behandlungszeit von etwa 500 s eine gute Entspiegelungswirkung erzielt wird.

Die Druckschrift US-A-4 390 276 offenbart ein Verfahren gemäß dem Oberbegriff des Anspruchs 1.

Die unterschiedliche Behandlungszeit für verschiedene Kunststoffsubstrate erschwert die gleichzeitige Entspiegelung von Kunststoffsubstraten aus verschiedenen Materialien in einem Arbeitsgang in der gleichen Vakuumkammer.

Der Erfindung liegt die Aufgabe zugrunde, ein verbessertes Verfahren zur Erzeugung einer Nanostruktur an einer Oberfläche eines Substrats aus einem Kunststoff mit einem Plasmaätzprozess anzugeben. Insbesondere soll das verbesserte Verfahren die Herstellung von Nanostrukturen mit vergleichsweise geringem Aufwand auf einer Vielzahl von Kunststoffen ermöglichen, wobei sich die erforderliche Behandlungszeit bei der Durchführung des Plasmaätzprozesses bei verschiedenen Substratmaterialien vorteilhaft nicht wesentlich voneinander unterscheidet.

Diese Aufgabe wird durch ein Verfahren mit den Merkmalen des Patentanspruchs 1 gelöst. Vorteilhafte Ausgestaltungen der Erfindung sind Gegenstand der abhängigen Ansprüche.

Bei dem erfindungsgemäßen Verfahren zur Erzeugung einer Nanostruktur an einer Oberfläche eines Substrats aus einem Kunststoff mit einem Plasmaätzprozess wird eine dünne Schicht auf das Kunststoffsubstrat aufgebracht und anschließend der Plasmaätzprozess durchgeführt.

Durch die Nanostruktur wird die Reflexion des Substrats vermindert. Es hat sich herausgestellt, dass sich Nanostrukturen zur Reflexionsminderung durch das Aufbringen einer dünnen Schicht vor der Durchführung des Plasmaätzprozesses auch auf Kunststoffsubstraten herstellen lassen, bei denen dies mit einem herkömmlichen Plasmaätzprozess nur schwer möglich ist oder vergleichsweise lange Behandlungszeiten erforderlich sind. Weiterhin hat sich vorteilhaft herausgestellt, dass sich die erforderliche Behandlungszeit für die Durchführung des Plasmaätzprozesses im Vergleich zu einem herkömmlichen Plasmaätzprozess verkürzt. Ein weiterer Vorteil des Verfahrens besteht darin, dass sich die erforderliche Dauer des Plasmaätzprozesses bei Substraten aus verschiedenen Kunststoffen vorteilhaft nur unwesentlich oder gar nicht voneinander unterscheidet. Dies ermöglicht die gleichzeitige Entspiegelung mehrerer Kunststoffsubstrate aus verschiedenen Kunststoffen in einem Arbeitsgang in der gleichen Vakuumkammer.

Die dünne Schicht, die vor der Durchführung des Plasmaätzprozesses auf das Kunststoffsubstrat aufgebracht wird, ist bevorzugt eine Oxidschicht, eine Nitridschicht oder eine Fluoridschicht. Insbesondere kann es sich bei der dünnen Schicht um eine Siliziumoxid-, Siliziumnitrid-, Titanoxid- oder Magnesiumfluoridschicht handeln.

Die Dicke der dünnen Schicht beträgt bevorzugt 2 nm oder weniger, besonders bevorzugt 1,5 nm oder weniger. Unter der Dicke der dünnen Schicht ist im Rahmen der Erfindung eine mittlere Schichtdicke zu verstehen, falls es sich bei der dünnen Schicht um eine nicht-kontinuierliche, insbesondere um eine inselförmige Schicht, handelt.

Das Aufbringen der dünnen Schicht erfolgt bevorzugt durch ein PVD (Physical Vapor Deposition)-Verfahren, insbesondere durch Sputtern oder Vakuumbedampfung. Beispielsweise kann eine dielektrische Oxid- oder Nitridschicht durch reaktives Sputtern, insbesondere Magnetronsputtern, von einem metallischen Target hergestellt werden.

Alternativ zum Aufbringen der dünnen Schicht mittels eines Vakuumbeschichtungsverfahrens kann die dünne Schicht auf der Oberfläche des Kunststoffsubstrats auch durch den Abrieb einer gummiartigen Schicht, ähnlich wie bei dem Abrieb eines Radiergummis, oder durch das Aufbringen und nachfolgendes Abreißen eines Klebebands erzeugt werden.

Der Plasmaätzprozess, der zur Bildung der reflexionsmindernd wirkenden Nanostruktur führt, wird vorzugsweise unmittelbar nach dem Aufbringen der dünnen Schicht durchgeführt. Die Durchführung des Plasmaätzprozesses erfolgt vorteilhaft mittels eines Plasmas, das Sauerstoff enthält. Ein geeigneter Plasmaätzprozess ist an sich aus der Patentschrift DE 10241708 B4, deren Offenbarungsgehalt diesbezüglich hiermit durch Referenz aufgenommen wird, bekannt.

Das erfindungsgemäße Verfahren ist insbesondere bei Kunststoffsubstraten anwendbar, die Polycarbonat, ein Cycloolefin-Polymer, Polyethersulfon, Polyetherimid, Polyamid, PET, PMMA oder CR39 enthalten.

Dabei wird im Vergleich zu einem herkömmlichen Plasmaätzprozess, der ohne das vorherige Aufbringen einer dünnen Schicht erfolgt, eine Reduzierung der erforderlichen Behandlungszeit erzielt. Bevorzugt beträgt die Dauer des Plasmaätzprozesses 400 s oder weniger, besonders bevorzugt sogar 300 s oder weniger.

Bei einer bevorzugten Ausführungsform des erfindungsgemäßen Verfahrens erfolgt die Erzeugung einer Nanostruktur auf mehreren Kunststoffsubstraten aus verschiedenen Kunststoffen gleichzeitig. Dies ist möglich, da sich die erforderliche Behandlungszeit zur Erzielung der bestmöglichen Entspiegelung bei verschiedenen Kunststoffen nicht oder nur unwesentlich voneinander unterscheidet.

Die mit dem Verfahren erzeugte Nanostruktur erstreckt sich vorteilhaft von der Oberfläche des Kunststoffsubstrats aus bis in eine Tiefe von 50 nm oder mehr in das Kunststoffsubstrat hinein. Besonders bevorzugt beträgt die Tiefe der Nanostruktur von der Oberfläche des Kunststoffsubstrats aus zwischen einschließlich 50 nm und 200 nm.

Das Kunststoffsubstrat kann bei dem erfindungsgemäßen Verfahren insbesondere ein optisches Element oder eine transparente Abdeckung sein, bei dem die Reflexion der Oberfläche vermindert werden soll. Bei einer weiteren bevorzugten Ausführungsform der Erfindung ist das Kunststoffsubstrat eine Kunststofffolie. Es hat sich herausgestellt, dass mit dem Verfahren auch vergleichsweise große Flächen mit einer Nanostruktur versehen werden können, insbesondere Flächen mit einer Größe von 50 cm x 50 cm oder mehr. Es können deshalb auch großflächige Folien mit einer Nanostruktur versehen werden können.

Durch die mit dem Verfahren erzeugte Nanostruktur wird die Reflexion der Oberfläche des Kunststoffsubstrats vermindert.

Bei dem erfindungsgemäßen Verfahren wird eine transparente Schutzschicht auf die Nanostruktur aufgebracht. Die transparente Schutzschicht schützt die die erzeugte Nanostruktur vor äußeren Einwirkungen, insbesondere vor mechanischen Beschädigungen, die beispielsweise bei der Reinigung der Oberfläche auftreten könnten.

Die Dicke der transparenten Schutzschicht wird vorzugsweise derart gewählt, dass einerseits die Nanostruktur ausreichend vor äußeren Einflüssen geschützt ist, andererseits aber die reflexionsmindernde Wirkung nicht verloren geht. Die Dicke der transparenten Schutzschicht beträgt zwischen einschließlich 10 nm und einschließlich 50 nm.

Besonders geeignet zur Ausbildung einer transparenten Schutzschicht ist ein Siliziumoxid, insbesondere SiO₂.

Die Erfindung wird im Folgenden anhand von Ausführungsbeispielen im Zusammenhang mit den Figuren 1 bis 4 näher erläutert.

Es zeigen:
Figuren 1 eine schematische grafische Darstellung eines Ausführungsbeispiels des erfindungsgemäßen Verfahrens anhand von Zwischenschritten,
Figuren 2 eine schematische grafische Darstellung eines weiteren Verfahrensschritts bei einem Ausführungsbeispiel des erfindungsgemäßen Verfahrens,
Figur 3 die Transmission in Abhängigkeit von der Wellenlänge bei einem mit dem erfindungsgemäßen Verfahren behandelten Kunststoffsubstrat aus Zeonex^{®} im Vergleich zu einem unbehandelten Kunststoffsubstrat aus Zeonex^{®}, und
Figur 4 die Transmission in Anhängigkeit von der Wellenlänge bei einem mit dem erfindungsgemäßen Verfahren behandelten Kunststoffsubstrat aus Ultrason^{®} im Vergleich zu einem unbehandelten Kunststoffsubstrat aus Ultrason^{®}.

Gleiche oder gleichwirkende Elemente sind in den Figuren mit den gleichen Bezugszeichen versehen. Die Figuren sind nicht als maßstabsgerecht anzusehen, vielmehr können einzelne Elemente zur Verdeutlichung übertrieben groß dargestellt sein.

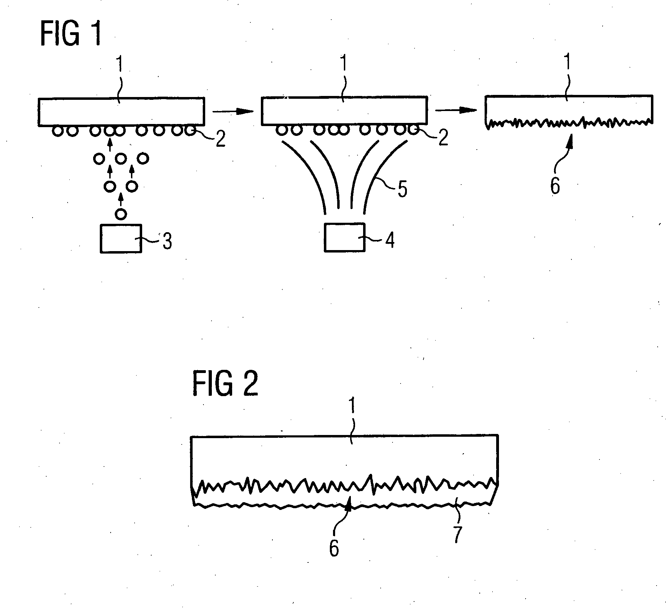

Wie in Figur 1 dargestellt, wird bei einem ersten Zwischenschritt eines erfindungsgemäßen Verfahrens eine dünne Schicht 2 auf ein Kunststoffsubstrat 1 aufgebracht..Das Kunststoffsubstrat weist vorzugsweise Polycarbonat, ein Cycloolefin-Polymer, Polyethersulfon, Polyetherimid, Polyamid, PET, PMMA oder CR39 auf. Insbesondere die Kunststoffe aus der Gruppe der Cycloolefin-Polymere, Polyethersulfone, Polyetherimide oder Polyamide können mit dem erfindungsgemäßen Verfahren im Vergleich zu einem herkömmlichen Plasmaätzverfahren mit vergleichsweise kurzen Ätzzeiten mit einer reflexionsmindernden Nanostruktur versehen werden. Vorteilhaft wird aber auch bei Kunststoffen wie PMMA oder CR39 eine Verkürzung der Prozessdauer gegenüber einem herkömmlichen Plasmaätzverfahren erzielt.

Die dünne Schicht 2, die auf das Kunststoffsubstrat 1 aufgebracht wird, ist vorzugsweise eine Oxidschicht, eine Nitridschicht oder eine Fluoridschicht. Insbesondere sind dünne Schichten aus TiO₂, SiO₂, MgF₂ oder aus einem Siliziumnitrid geeignet.

Bei der dünnen Schicht 2 handelt es sich vorzugsweise um eine inselförmige Schicht, das heißt um eine Schicht, deren Wachstum derart im Anfangsstadium unterbrochen wurde, dass die Schicht noch nicht zu einer kontinuierlichen Schicht zusammengewachsen ist.

Die dünne Schicht 2 weist bevorzugt eine Dicke von 2 nm oder weniger, besonders bevorzugt von 1,5 nm oder weniger auf. Unter der Dicke der dünnen Schicht 2 wird dabei, da es sich bei der dünnen Schicht 2 insbesondere um eine inselförmige Schicht handeln kann, eine über die Oberfläche des Kunststoffsubstrats 1 gemittelte Dicke verstanden. Die mittlere Dicke der dünnen Schicht 2 kann beim Aufwachsen beispielsweise mit einem kalibrierten Schwingquarzmesssystem bestimmt werden, wobei die mittlere Schichtdicke aus der auf das Substrat aufgebrachten Masse berechnet wird. Die mittlere Dicke der inselförmigen dünnen Schicht entspricht der Dicke einer geschlossenen gleichmäßig dicken Schicht, die die gleiche Masse wie die tatsächlich aufgebrachte inselförmige Schicht aufweist.

Das Aufbringen der dünnen Schicht 2 auf das Kunststoffsubstrat 1 erfolgt beispielsweise durch Vakuumbedampfung aus einer Verdampfungsquelle 3. Insbesondere kann es sich bei der Verdampfungsquelle 3 um eine Elektronenstrahlverdampfungsquelle oder um eine thermische Verdampfungsquelle handeln. Alternativ können auch andere PVD-Verfahren zum Aufbringen der dünnen Schicht 2 eingesetzt werden. Insbesondere ist das Aufbringen durch Sputtern, zum Beispiel durch reaktives Magnetronsputtern, geeignet. Das Aufbringen der dünnen Schicht 2 mittels Sputterns hat den Vorteil, dass auch vergleichsweise große Flächen eines Kunststoffsubstrats 1 homogen mit der dünnen Schicht 2 beschichtet werden können. Beispielsweise ist es möglich, auch größere Kunststoffsubstrate mit einer Größe von beispielsweise 50 cm x 50 cm oder mehr zu beschichten.

Nach dem Aufbringen der dünnen Schicht 2 auf das Kunststoffsubstrat 1 wird ein Plasmaätzprozess zur Erzeugung einer Nanostruktur an der Oberfläche des Kunststoffsubstrats 1 durchgeführt. Zur Erzeugung des Plasmas wird beispielsweise eine Plasmaionenquelle 4 eingesetzt. Insbesondere kann es sich bei dem Plasma um ein Argonplasma handeln, dem Sauerstoff zugeführt wird. In dem Plasma 5 werden hochenergetische Ionen zum Substrat hin beschleunigt und erzeugen auf diese Weise die Nanostruktur. Eine geeignete Plasmaionenquelle 4 und zur Durchführung des Plasmaätzprozesses geeignete Betriebsparameter sind beispielsweise aus der Druckschrift DE 10241708 B4 bekannt und werden daher an dieser Stelle nicht näher erläutert. Anstelle dieser im Stand der Technik beschriebenen Plasmaionenquelle, die typischerweise in Vakuumbedampfungsanlagen zur thermischen und/oder Elektronenstrahlverdampfung eingesetzt wird, kann der Plasmaätzprozess auch mit anderen Plasmaquellen durchgeführt werden. Zum Beispiel ist auch eine Hochfrequenz-Plasmaquelle geeignet, die als Ätzstation in einer Sputteranlage angeordnet sein kann.

Es hat sich vorteilhaft herausgestellt, dass sich die erforderliche Dauer des Plasmaätzprozesses durch das vorherige Aufbringen der dünnen Schicht 2 im Vergleich zu dem in der zuvor genannten Druckschrift beschriebenen Verfahren vorteilhaft verkürzt. Insbesondere kann die Dauer des Plasmaätzprozesses 400 s oder weniger, bevorzugt 300 s oder weiniger, betragen. Die Dauer des Ätzprozesses kann anhand von Messungen der spektralen Transmission von Proben, die mit verschiedenen Ätzzeiten behandelt wurden, optimiert werden. Bei einer zu kurzen Ätzzeit kann eine unerwünschte Verschiebung des Reflexionsminimums zu einer kürzeren Wellenlänge hin erfolgen, während bei zu langen Ätzzeiten Streulichtverluste in der Nanostruktur auftreten.

Durch den Plasmaätzprozess wird an der Oberfläche des Kunststoffsubstrats 1 die Nanostruktur 6 erzeugt. Die zuvor aufgebrachte dünne Schicht 2 kann bei dem Plasmaätzprozess ganz oder teilweise von der Oberfläche des Kunststoffsubstrats 1 abgetragen werden. Die Nanostruktur 6 erstreckt sich vorzugsweise von der Oberfläche des Kunststoffsubstrats 1 bis in eine Tiefe von mehr als 50 nm in das Substrat hinein. Besonders bevorzugt erstreckt sich die Nanostruktur 6 sogar bis in eine Tiefe von 100 nm oder mehr in das Substrat hinein. In lateraler Richtung betragen die Strukturgrößen der Nanostruktur vorzugsweise 70 nm oder weniger, das heißt es wird ein vergleichsweise großes Aspektverhältnis erzielt.

Bei einer bevorzugten Ausführungsform der Erfindung wird, wie in Figur 2 dargestellt ist, nach der Erzeugung der Nanostruktur 6 an der Oberfläche des Kunststoffsubstrats 1 eine transparente Schutzschicht 7 auf die Nanostruktur 6 aufgebracht. Durch die transparente Schutzschicht 7 wird die Nanostruktur 6 vor äußeren Einflüssen, insbesondere vor einer mechanischen Beschädigung geschützt. Insbesondere wird dadurch die Gefahr vermindert, dass die Nanostruktur bei einer Reinigung der Oberfläche des Kunststoffsubstrats 1 beschädigt wird.

Es wurde festgestellt, dass die transparente Schutzschicht 7 die Nanostruktur 6 nur bei sehr geringen Schichtdicken von weniger als 10 nm nachbildet. Bei größeren Schichtdicken bildet sich eine geschlossene Schicht aus, die die Nanostruktur ausreichend vor mechanischen Beschädigungen z.B. beim Abwischen der Oberfläche schützt. Dabei wird die reflexionsmindernde Wirkung der erzeugten Nanostruktur 6 durch die dünne transparente Schicht nicht oder nur unwesentlich beeinträchtigt, wenn die Schichtdicke 50 nm, besonders bevorzugt 40nm, nicht übersteigt. Bevorzugt weist die transparente Schutzschicht daher eine Dicke zwischen einschließlich 10 nm und einschließlich 50 nm auf.

Um die reflexionsmindernde Wirkung der Nanostruktur 6 nicht zu beeinträchtigen, ist es weiterhin vorteilhaft, wenn die transparente Schutzschicht einen geringen Brechungsindex aufweist. Bevorzugt ist die transparente Schutzschicht eine SiO₂-Schicht.

Wenn eine transparente Schutzschicht 7 auf die Nanostruktur 6 aufgebracht wird, ist es vorteilhaft, wenn die Dauer des vorherigen Ätzprozesses kürzer als bei dem Verfahren ohne nachträgliches Aufbringen einer Schutzschicht gewählt wird. Vorzugsweise beträgt die Dauer des Ätzprozesses bei dieser Ausführungsform der Erfindung 200 s oder weniger.

Aufgrund der reflexionsmindernden Wirkung der Nanostruktur 6 ist das erfindungsgemäße Verfahren insbesondere für Kunststoffsubstrate 1 geeignet, bei denen eine Reflexion von einfallender Strahlung unerwünscht ist, beispielsweise bei transparenten Abdeckungen von Displays oder bei optischen Elementen.

Insbesondere kann das erfindungsgemäße Verfahren auch für großflächige Kunststoffsubstrate 1 verwendet werden, beispielsweise für großflächige Abdeckungen von optischen Anzeigeelementen oder zur Entspiegelung von Kunststofffolien.

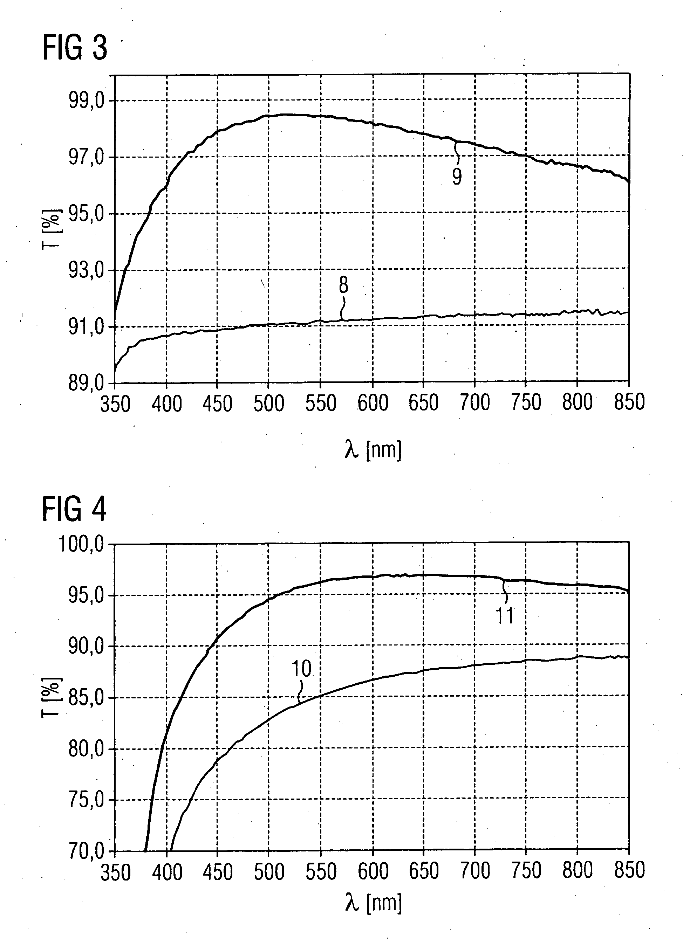

In Figur 3 ist die gemessene Transmission eines beidseitig mit dem erfindungsgemäßen Verfahren behandelten Kunststoffsubstrats aus Zeonex^{®} (Kurve 9) im Vergleich zu einem unbehandelten Zeonex^{®}-Substrat (Kurve 8) dargestellt. Die Messkurven 8, 9 verdeutlichen, dass insbesondere die Transmission im sichtbaren Spektralbereich durch die Erzeugung von Nanostrukturen an beiden gegenüberliegenden Oberflächen des Kunststoffsubstrats mit dem erfindungsgemäßen Verfahren erheblich verbessert werden kann.

Das bei diesem Ausführungsbeispiel verwendete Kunststoffsubstrat aus Zeonex^{®} zeichnet sich durch eine vergleichsweise gute Wärmeformbeständigkeit, beispielsweise im Vergleich zu PMMA, aus und ist insbesondere bis zu einer Temperatur von etwa 125 °C einsetzbar. Die dargestellte Transmissionsmessung (Kurve 9) wurde an einer Probe mit 55 mm Durchmesser und einer Dicke von 1 mm durchgeführt, die beidseitig mittels des erfindungsgemäßen Verfahrens mit einer Nanostruktur versehen wurde. Zur Herstellung der Nanostruktur wurde in einer Vakuumbedampfungsanlage APS904 (Leybold Optics) eine dünne TiO₂-Schicht mittels Elektronenstrahlverdampfung auf das Kunststoffsubstrat abgeschieden. Dies kann beispielsweise bei einem Prozessdruck von etwa 1 x 10⁻⁵ mbar erfolgen. Die TiO₂-Schicht wurde mit einer Dicke von etwa 1,25 nm bei einer Aufdampfrate von 0,03 nm/s abgeschieden, wobei die Schichtdicke während des Aufwachsens mittels eines kalibrierten Schwingquarzmesssystems detektiert wurde. Das Aufwachsen der dünnen Schicht erfolgte auf ein unbehandeltes Substrat, insbesondere wurde vor dem Aufwachsen der dünnen Schicht keine Plasmavorbehandlung durchgeführt.

Die Erzeugung der Nanostruktur mittels eines Plasmaätzprozesses erfolgte mittels einer in die Vakuumbedampfungsanlage eingebauten Plasmaionenquelle ohne eine zwischenzeitige Unterbrechung des Vakuumzyklus. Zur Durchführung des Ätzvorgangs wurden Argon mit einer Flussrate von 14 sccm und Sauerstoff mit einer Flussrate von 30 sccm in die Vakuumkammer eingelassen. Die Plasmaionenquelle wurde mit einer BIAS-Spannung, die ein Maß für die Energie der am Substratträger auftreffenden Ar-Ionen ist, von 120 V und einem Entladestrom von 50 A betrieben. Der Ätzprozess wurde mit diesen Prozessparametern mit einer Dauer von 300 s durchgeführt. Es hat sich herausgestellt, dass bei längeren Ätzzeiten Streulichtverluste in der mit der Nanostruktur versehenen Probe auftreten, während bei kürzeren Ätzzeiten noch nicht die bestmögliche Reflexionsminderung im sichtbaren Spektralbereich erzielt wird.

In Figur 3 ist die gemessene Transmission in Abhängigkeit von der Wellenlänge für ein unbehandeltes (Kurve 10) und ein mit dem erfindungsgemäßen Verfahren behandeltes (Kurve 11) Kunststoffsubstrat aus dem Polyethersulfon Ultrason^{®} E2010 dargestellt. Bei diesem Polymer handelt es sich um ein Thermoplast mit einer vergleichsweise hohen Wärmeformbeständigkeit bis in einen Temperaturbereich von über 200 °C. Es zeichnet sich durch einen vergleichsweise hohen Brechungsindex von n = 1,65 aus, der für viele optische Anwendungen vorteilhaft ist, jedoch an einer Grenzfläche zur Luft zu nachteilig hohen Reflexionsverlusten führen kann.

Die gemessenen Transmissionskurven 10 und 11 verdeutlichen, dass die Transmission der bei dem Ausführungsbeispiel verwendeten 1,5 mm dicken Probe aus Ultrason^{®} insbesondere im sichtbaren Spektralbereich durch die Behandlung mit dem erfindungsgemäßen Verfahren erhöht werden konnte, wobei beispielsweise bei einer Wellenlänge von 550 nm eine Steigerung der Transmission von mehr als 10 % erzielt wurde.

Zur Herstellung der Probe wurde eine Silizium-Nitridschicht mit einer Dicke von etwa 1 nm auf das Kunststoffsubstrat abgeschieden. Die Abscheidung der dünnen Silizium-Nitridschicht erfolgte in einer Magnetron-Sputteranlage durch reaktives DC-Sputtern bei einer Leistung von 300 W in einem Ar/N₂-Plasma von einem Si-Target, wobei Argon mit einer Flussrate von 10 sccm und Stickstoff mit einer Flussrate von 15 sccm in die Vakuumkammer eingelassen wurden.

Die Erzeugung der Nanostruktur erfolgte mit einem Ätzvorgang, der ohne vorherige Unterbrechung des Vakuumzyklus in einer Ätzstation der Sputteranlage durchgeführt wurde. Das Ätzen erfolgte in einem Argon/Sauerstoffplasma. Dabei wurde ein Hochfrequenz-Plasma mit einer Frequenz von 13,56 MHz und einer Plasmaleistung von 100 W eingesetzt, wobei Argon mit einer Flussrate von 10 sccm und Sauerstoff mit einer Flussrate von 20 sccm in die Vakuumkammer eingeleitet wurden. Wie bei dem zuvor dargestellten Ausführungsbeispiel hat sich herausgestellt, dass die Ätzzeit zur Erzielung der bestmöglichen Reflexionsverminderung etwa 300 s beträgt.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Verfahren zur Erzeugung einer Nanostruktur (6) an einer Oberfläche eines Substrats (1) aus einem Kunststoff mit einem Plasmaätzprozess, wobei die Nanostruktur (6) die Reflexion des Substrats (1) vermindert,
wobei eine dünne Schicht (2), die eine mittlere Dicke von 2 nm oder weniger aufweist, auf das Substrat (1) aufgebracht wird und nachfolgend der Plasmaätzprozess durchgeführt wird, **dadurch gekennzeichnet, dass** eine transparente Schutzschicht (7) auf die Nanostruktur (6) aufgebracht wird, wobei die transparente Schutzschicht (7) eine Dicke zwischen einschließlich 10 nm und einschließlich 50 nm aufweist.

2. Verfahren nach Anspruch 1,
**dadurch gekennzeichnet, dass**
die dünne Schicht (2) eine Oxidschicht, eine Nitridschicht oder eine Fluoridschicht ist.

3. Verfahren nach Anspruch 2,
**dadurch gekennzeichnet, dass**
die dünne Schicht (2) Siliziumoxid, Siliziumnitrid, Titanoxid oder Magnesiumfluorid enthält.

4. Verfahren nach einem der vorhergehenden Ansprüche,
**dadurch gekennzeichnet, dass**
die dünne Schicht (2) durch Sputtern oder Vakuumbedampfung aufgebracht wird.

5. Verfahren nach einem der vorhergehenden Ansprüche,
**dadurch gekennzeichnet, dass**
die dünne Schicht (2) durch Abrieb einer gummiartigen Schicht oder durch das Aufbringen und Abreißen eines Klebebands aufgebracht wird.

6. Verfahren nach einem der vorhergehenden Ansprüche,
**dadurch gekennzeichnet, dass**
die dünne Schicht (2) eine inselförmige Schicht ist.

7. Verfahren nach einem der vorhergehenden Ansprüche,
**dadurch gekennzeichnet, dass**
das Substrat (1) ein Polycarbonat, ein Cycloolefin-Polymer, ein Polyethersulfon, ein Polyetherimid, ein Polyamid, PET, PMMA oder CR39 enthält.

8. Verfahren nach einem der vorhergehenden Ansprüche,
**dadurch gekennzeichnet, dass**
die Dauer des Plasmaätzprozesses 400 s oder weniger beträgt.

9. Verfahren nach einem der vorhergehenden Ansprüche,
**dadurch gekennzeichnet, dass**
die Erzeugung der Nanostruktur (6) auf mehreren Substraten (1) aus verschiedenen Kunststoffen gleichzeitig in derselben Vakuumkammer durchgeführt wird.

10. Verfahren nach einem der vorhergehenden Ansprüche,
**dadurch gekennzeichnet, dass**
sich die Nanostruktur (6) von der Oberfläche des Substrats (1) aus bis in eine Tiefe von 50 nm oder mehr in das Substrat (1) hinein erstreckt.

11. Verfahren nach Anspruch 10,
**dadurch gekennzeichnet, dass**
sich die Nanostruktur (6) von der Oberfläche des Substrats (1) aus bis in eine Tiefe zwischen 50 nm und 200 nm in das Substrat (1) hinein erstreckt.

12. Verfahren nach einem der vorhergehenden Ansprüche,
**dadurch gekennzeichnet, dass**
das Substrat (1) ein optisches Element ist.

13. Verfahren nach einem der Ansprüche 1 bis 11,
**dadurch gekennzeichnet, dass**
das Substrat (1) eine transparente Abdeckung einer optischen Anzeigevorrichtung ist.

14. Verfahren nach einem der Ansprüche 1 bis 11,
**dadurch gekennzeichnet, dass**
das Substrat (1) eine Kunststofffolie ist.

15. Verfahren nach einem der vorhergehenden Ansprüche,
**dadurch gekennzeichnet, dass**
die transparente Schutzschicht (7) eine SiO₂-Schicht ist.

16. Verfahren nach einem der vorhergehenden Ansprüche,
**dadurch gekennzeichnet, dass**
die Dauer des Plasmaätzprozesses 200 s oder weniger beträgt.

## Claims

1. Method for producing a nanostructure (6) at a surface of a substrate (1) composed of a plastic by means of a plasma etching process, wherein the nanostructure (6) reduces the reflection of the substrate (1),
wherein a thin layer (2) having an average thickness of 2 nm or less is applied to the substrate (1) and the plasma etching process is subsequently carried out, **characterized in that** a transparent protective layer (7) is applied to the nanostructure (6), wherein the transparent protective layer (7) has a thickness of between 10 nm and 50 nm inclusive.

2. Method according to Claim 1,
**characterized in that**
the thin layer (2) is an oxide layer, a nitride layer or a fluoride layer.

3. Method according to Claim 2,
**characterized in that**
the thin layer (2) contains silicon oxide, silicon nitride, titanium oxide or magnesium fluoride.

4. Method according to any of the preceding claims,
**characterized in that**
the thin layer (2) is applied by sputtering or vacuum vapor deposition.

5. Method according to any of the preceding claims,
**characterized in that**
the thin layer (2) is applied by abrading a rubberlike layer or by applying and tearing off an adhesive tape.

6. Method according to any of the preceding claims,
**characterized in that**
the thin layer (2) is an insular layer.

7. Method according to any of the preceding claims,
**characterized in that**
the substrate (1) contains a polycarbonate, a cycloolefin polymer, a polyether sulfone, a polyetherimide, a polyamide, PET, PMMA or CR39.

8. Method according to any of the preceding claims,
**characterized in that**
the duration of the plasma etching process is 400 s or less.

9. Method according to any of the preceding claims,
**characterized in that**
the production of the nanostructure (6) on a plurality of substrates (1) composed of different plastics is carried out simultaneously in the same vacuum chamber.

10. Method according to any of the preceding claims,
**characterized in that**
the nanostructure (6) extends from the surface of the substrate (1) down to a depth of 50 nm or more into the substrate (1).

11. Method according to Claim 10,
**characterized in that**
the nanostructure (6) extends from the surface of the substrate (1) down to a depth of between 50 nm and 200 nm into the substrate (1).

12. Method according to any of the preceding claims,
**characterized in that**
the substrate (1) is an optical element.

13. Method according to any of Claims 1 to 11,
**characterized in that**
the substrate (1) is a transparent covering of an optical display device.

14. Method according to any of Claims 1 to 11,
**characterized in that**
the substrate (1) is a plastic film.

15. Method according to any of the preceding claims,
**characterized in that**
the transparent protective layer (7) is an SiO₂ layer.

16. Method according to any of the preceding claims,
**characterized in that**
the duration of the plasma etching process is 200 s or less.

## Revendications

1. Procédé de production d'une nanostructure (6) sur une surface d'un substrat (1) en une matière plastique avec un procédé de gravure au plasma, dans lequel la nanostructure (6) diminue la réflexion du substrat (1), dans lequel on dépose sur le substrat (1) une couche mince (2), qui présente une épaisseur moyenne de 2 nm ou moins, et on effectue ensuite le procédé de gravure au plasma, **caractérisé en ce que** l'on dépose une couche de protection transparente (7) sur la nanostructure (6), dans lequel la couche de protection transparente (7) présente une épaisseur comprise entre 10 nm et 50 nm, ces deux valeurs comprises.

2. Procédé selon la revendication 1, **caractérisé en ce que** la couche mince (2) est une couche d'oxyde, une couche de nitrure ou une couche de fluorure.

3. Procédé selon la revendication 2, **caractérisé en ce que** la couche mince (2) contient de l'oxyde de silicium, du nitrure de silicium, de l'oxyde de titane ou du fluorure de magnésium.

4. Procédé selon l'une quelconque des revendications précédentes, **caractérisé en ce que** l'on dépose la couche mince (2) par pulvérisation cathodique ou par vaporisation sous vide.

5. Procédé selon l'une quelconque des revendications précédentes, **caractérisé en ce que** l'on dépose la couche mince (2) par abrasion d'une couche caoutchouteuse ou par l'application et l'enlèvement d'une bande adhésive.

6. Procédé selon l'une quelconque des revendications précédentes, **caractérisé en ce que** la couche mince (2) est une couche en forme d'îlots.

7. Procédé selon l'une quelconque des revendications précédentes, **caractérisé en ce que** le substrat (1) contient un polycarbonate, un polymère de cyclo-oléfine, un polyéthersulfone, un polyétherimide, un polyamide, PET, PMMA ou CR39.

8. Procédé selon l'une quelconque des revendications précédentes, **caractérisé en ce que** la durée du procédé de gravure au plasma vaut 400 s ou moins.

9. Procédé selon l'une quelconque des revendications précédentes, **caractérisé en ce que** l'on effectue la production de la nanostructure (6) simultanément sur plusieurs substrats (1) en matières plastiques différentes dans la même chambre sous vide.

10. Procédé selon l'une quelconque des revendications précédentes, **caractérisé en ce que** la nanostructure (6) s'étend à partir de la surface du substrat (1) jusqu'à une profondeur de 50 nm ou plus à l'intérieur du substrat (1).

11. Procédé selon la revendication 10, **caractérisé en ce que** la nanostructure (6) s'étend à partir de la surface du substrat (1) jusqu'à une profondeur comprise entre 50 nm et 200 nm à l'intérieur du substrat (1).

12. Procédé selon l'une quelconque des revendications précédentes, **caractérisé en ce que** le substrat (1) est un élément optique.

13. Procédé selon l'une quelconque des revendications 1 à 11, **caractérisé en ce que** le substrat (1) est un recouvrement transparent d'un dispositif d'affichage optique.

14. Procédé selon l'une quelconque des revendications 1 à 11, **caractérisé en ce que** le substrat (1) est un film de matière plastique.

15. Procédé selon l'une quelconque des revendications précédentes, **caractérisé en ce que** la couche de protection transparente (7) est une couche de SiO₂.

16. Procédé selon l'une quelconque des revendications précédentes, **caractérisé en ce que** la durée du procédé de gravure au plasma vaut 200 s ou moins.
